# EUROPEAN PATENT APPLICATION

(11) **EP 0 757 115 A1**
(43) Date of publication of application: **05.02.1997**
(21) Application number: 96305719.5
(22) Date of filing: 02.08.1996
(51) Int. Cl.: C23C 14/06, F16C 33/12

(54) **Pivot thrust bearing system**

(30) Priority: 03.08.1995 JP 198537/95
(71) Applicant: MATSUSHITA ELECTRIC INDUSTRIAL CO., LTD., Kadoma-shi Osaka (JP)
(72) Inventor: Nakamura, Kazuya, Toyonaka-shi, Osaka (JP); Murano, Katsuhiro, Ootsu-shi, Shiga-ken (JP); Kurozumi, Seiji, Katano-shi, Osaka (JP); Yamashita, Fumitoshi, Ikoma-shi, Nara-ken (JP)
(74) Representative: Senior, Alan Murray

(57) **Abstract**

To stabilize a mixed lubricating condition in a pivot thrust bearing, a rotary shaft is made of steel material by directly applying a double ion implantation of metal element and carbon. An ion-implantation surface of this rotary shaft is brought into slidable contact with a bearing through a lubricating oil component. Especially, the metal element directly implanted into the rotary shaft is titanium (Ti), and an implantation amount of the titanium (Ti) is not smaller than 2.5 x 10¹⁷ dose (ions/cm²), while an implantation amount of the carbon is equivalent to or larger than the implantation amount of the titanium (Ti). Furthermore, the steel material constituting the rotary shaft has Vickers hardness not smaller than Hv500, and a sliding portion of the bearing is made of metal or ceramic having Vickers hardness not smaller than Hv550.

## Description

This invention generally relates to a pivot thrust bearing system preferably used for spindle motors or the like.

In the technical field of high-speed high-density recording of data by magnetic disk apparatus, a need for spindle motors capable of performing a highly accurate and high-speed operation has been increasing.

In accordance with the requirement of high accuracy and high speed, it is necessary to reduce ageing-like dislocation of a rotary shaft of a spindle motor in its axial direction. To this end, it is usual that the rotary shaft is supported by a fluid radial bearing. Even in the case that the rotary shaft is supported by a thrust bearing, to suppress the ageing-like dislocation of the rotary shaft in the axial direction, there is proposed a technology of maintaining a non-contact sliding condition utilizing a dynamic pressure generated by a hydraulic force of lubricating oil in response to the rotation of the rotary shaft, as disclosed in Laid-open Japanese Patent Application No. HEI 6-38442, published in 1994.

Maintaining the non-contact sliding condition by generating dynamic pressure using hydraulic force of lubricating oil in response to the rotation of the rotary shaft as disclosed in the Laid-open Japanese Patent Application No. HEI 6-38442 will be an ideal lubricating condition. However, when the thickness of lubricating oil film intervening between solid members is reduced to a degree of surface roughness of the solid members, there is a possibility that confronting solid members may be brought into direct contact with each other somewhere in their sliding surfaces and the wear amount caused therebetween will be significantly increased compared with that in the fluid lubricating condition; such a condition is generally referred to as boundary lubricating condition.

In an actual sliding surface, a load acting in an axial direction is applied from a driven member, such as a magnetic recording medium, to the thrust bearing via the rotary shaft. Accordingly, even if the fluid bearing is adopted, an actual lubricating condition realized will be a somewhat mixed lubricating condition where the boundary lubricating condition is complicatedly involved at a certain degree. Hence, in practice, it was impossible to realize a perfect fluid thrust bearing capable of generating a stable dynamic pressure by the hydraulic force of lubricating oil in accordance with the rotation of the rotary shaft, so as to maintain the non-contact sliding condition.

### SUMMARY OF THE INVENTION

Accordingly, in view of above-described problems encountered in the prior art, an aim of the present invention is to provide an excellent pivot thrust bearing system capable of stabilizing a mixed lubricating condition by preventing a rotary shaft from causing a dislocation in its axial direction and also reducing its dispersion, thereby complying with the needs of high accuracy and high speed or low power consumption, for example, in spindle motors which drive magnetic disk apparatuses or the like.

The present invention provides a pivot thrust bearing system comprising a rotary shaft made of steel material having an ion-implantation surface to which has been applied a direct ion implantation of metal element and carbon. The ion-implantation surface of the rotary shaft is brought into slidable contact with a bearing through a lubricating oil component. Specifically, the metal element implanted into the rotary shaft is titanium (Ti), and an implantation amount of the titanium (Ti) is not smaller than 2.5 x 10¹⁷ dose (ions/cm²), while an implantation amount of the carbon is equivalent to or larger than the implantation amount of the titanium (Ti).

According to features of the preferred embodiments, it is preferable that the steel material constituting the rotary shaft has Vickers hardness not smaller than Hv500, and a sliding portion of the bearing brought into slidable contact with the ion-implantation surface of the rotary shaft through the lubricating oil composition is made of metal or ceramic having Vickers hardness not smaller than Hv550.

Furthermore, it is preferable that the steel material constituting the rotary shaft is stainless steel (SUS420J2). And, an ion implantation temperature of an ion-implantation surface of the steel material is not larger than 525 °C in performing the ion implantation.

Moreover, it is preferable that the sliding portion of the bearing is made of SIALON having a composition of Si_{6-0.75x}Al_{0.07x}OᵣN₈₋ₓ (x≤6) and having Vickers hardness not smaller than Hv1300.

The above and other features and advantages of the present invention will become more apparent from the following detailed description of exemplary embodiments and the accompanying drawings, in which:
Fig. 1 is a graph showing measuring data of an ion-implantation surface temperature in the ion implantation;
Fig. 2 is a graph showing the relationship between the annealing temperature and the hardness in stainless steel SUS420J2;
Fig. 3 is a graph showing an influence of titanium (Ti) implantation amount given to the wear characteristics;
Fig. 4 is a graph showing an influence of hardness of the sliding portion material given to the friction coefficient;
Fig. 5A is a view illustrating a first method for setting the rotary shaft in the ion implantation;
Fig. 5B is a view illustrating a second method for setting the rotary shaft in the ion implantation; and
Fig. 6 is a graph showing an influence of the rotational setting method given to the friction coefficient when the rotary shaft material is SUS420J2.

### DETAILED DESCRIPTION OF THE PREFERRED EMBODIMENTS

As disclosed in an earlier Japanese Patent Application No. HEI 7-52133, filed in 1995, the inventors of this application have already proposed a bearing system capable of suppressing an axial-directional dislocation of the rotary shaft of a spindle motor to stabilize the sliding condition in the mixed lubricating condition in the motor bearing system. According to this technology, a rotary shaft is made of steel material containing metal element selected from the group consisting of IVa, Va and VIa groups in the periodic table and carbon which are directly ion implanted into the steel material, so that an ion-implantation surface of the rotary shaft is brought into slidable contact with a bearing member through lubricating oil component.

However, the specific wear amount in the mixed lubricating condition has a large dispersion although its value can be suppressed within a range smaller than 10⁻¹¹m²/N. Regarding the influence of Ti amount implanted into the rotary shaft and the influence of hardness of the rotary shaft material and the sliding portion material of the bearing, many of them remain unclear.

In general, implantation amount (dose) is defined by a product of the beam current and the processing time in the ion implantation. When high-density element of 10¹⁶ to 10²⁰ dose (ions/cm²) is ion implanted, it is normally necessary to increase either the beam current or the processing time. In addition, the inside of the chamber has a poor heat radiation efficiency since the inside of the chamber is maintained at a high vacuum condition of 10⁻⁶ to 10⁻⁸ Torr. Hence, the temperature in the vicinity of the ion-implantation portion is increased to a high temperature. If the rotary shaft is made of quenching material, there will be a possibility that it may be annealed due to the temperature increase in the vicinity of the ion-implantation portion, causing an undesirable deterioration of the hardness of the material.

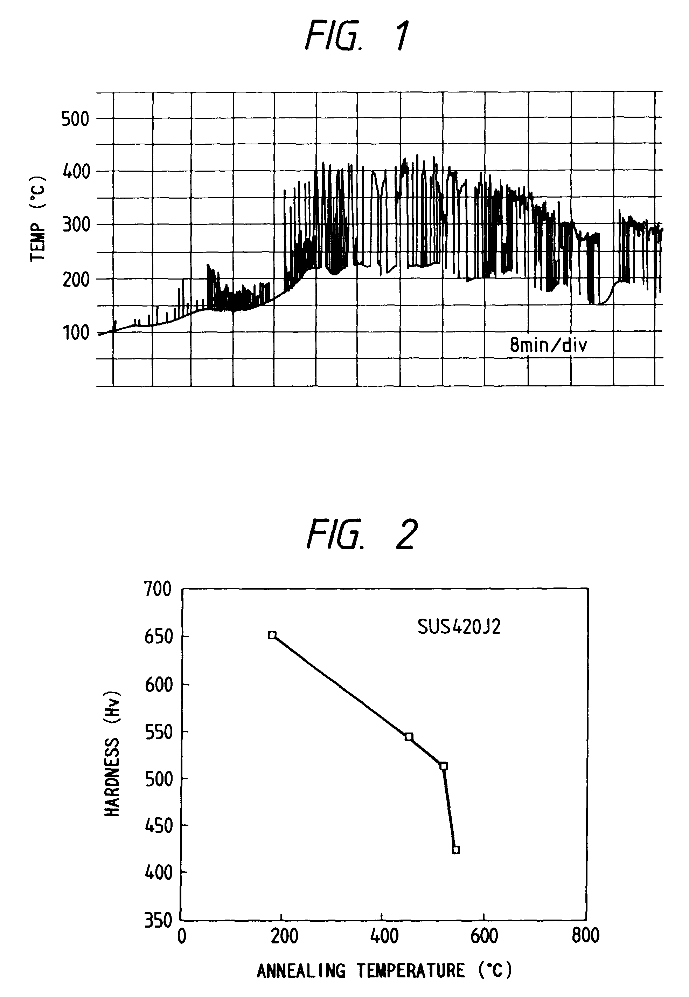

For example, it is assumed that an end surface of stainless steel (SUS420J2), having an outer diameter of 3mm and a length of 60mm with the hardness of Hv651, is shaped into a spherical face having a radius of 4mm. When ion beam (beam current of 15 mA) is continuously irradiated on this end surface of stainless steel (SUS420J2) by the method disclosed in the earlier Japanese Patent Application No. HEI 7-52133, the temperature of an ion-implantation surface reaches to 430 °C as shown in Fig. 1 and the hardness is reduced to Hv551 as apparent from Fig. 2.

When the hardness of the rotary shaft material is constant, it is apparent from the disclosure of the earlier Japanese Patent Application No. HEI 7-52133 that the wear resistance of an ion-implantation modified surface is improved. However, regarding the influence of hardness of the rotary shaft material given to the sliding characteristics, many things remain uncertain. Therefore, in setting the conditions for the ion implantation, there will be a necessity of making it clear what kind of limitation is required with respect to the temperature of the ion-implantation surface.

In view of the foregoing, the present invention proposes to realize a stable sliding condition by specifying optimum ranges with respect to the titanium (Ti) implantation amount, the hardness of the materials used for the rotary shaft and the sliding portion of the bearing, and the temperature of the rotary shaft material and the ion-implantation surface in the ion implantation.

More specifically, the present invention provides a pivot thrust bearing system comprising a rotary shaft made of steel material containing metal element and carbon which are directly ion implanted into the steel material. And, an ion-implantation surface of the rotary shaft is brought into slidable contact with a bearing through a lubricating oil component. Especially, the metal element directly implanted into the rotary shaft is titanium (Ti), and an implantation amount of the titanium (Ti) is not smaller than 2.5 x 10¹⁷ dose (ions/cm²), while an implantation amount of the carbon is equivalent to or larger than the implantation amount of the titanium (Ti).

Preferably, the steel material constituting the rotary shaft has Vickers hardness not smaller than Hv500, and a sliding portion of the bearing brought into slidable contact with the ion-implantation surface of the rotary shaft through the lubricating oil composition is made of metal or ceramic having Vickers hardness not smaller than Hv550. Furthermore, the steel material constituting the rotary shaft is stainless steel (SUS420J2). The sliding portion of the bearing is made of SIALON having a composition of Si_{6-0.75x}Al_{0.07x}OₓN₈₋ₓ (x≤6) and having Vickers hardness not smaller than Hv1300.

Yet further, when the ion-implantation rotary shaft of the present invention is made of stainless steep (SUS420J2), it is preferable that an ion-implantation temperature of this steel material is not larger than 525 °C in performing the ion implantation.

The lubricating oil composition intervening between the rotary shaft and the bearing in accordance with the present invention is mineral oil group or synthetic oil group hydrocarbon base oil containing an appropriate amount of additive agent, such as viscosity index improver, extreme-pressure additive, oxidation inhibitor, pour point improver, defoamer, which is used as ordinary bearing oil. Furthermore, it is possible to further contain or use grease, or powder having a layer lattice structure such as graphite, MOS₂ and BN, or metal thin film such as In, Cu and Pb. Detailed composition of the lubricating oil composition ruling the mixed lubricating condition should be adequately determined based on the structure and actual load conditions of a motor to be operated.

It is also possible to arrange the bearing portion in a complex structure comprising metal or ceramic having Vickers hardness not smaller than Hv550 and an easily machinable material where the metal or ceramic is limited to the sliding portion only.

Hereinafter, the present invention will be explained in more detail.

First explained will be what kind of influence is given to the sliding performance by the amount of titanium (Ti) implanted into the rotary shaft, in a pivot thrust bearing system for a motor by which a rotary shaft causes a slide motion against a bearing through lubricating oil.

In improving the wear resistance of the surface-modified layer, the effect of double ion-implantation of titanium (Ti) ion and carbon ion into steel material is disclosed in the earlier Japanese Patent Application No. HEI 7-52133, filed in 1995.

Furthermore, according to the study of inventors of this application, it is found that excellent friction coefficient is obtained by the double ion-implantation of titanium (Ti) ion and carbon ion. More specifically, when a non-modified end surface of a stainless steel (SUS420J2) pin was slid on a disk-like SIALON under a mixed lubricating condition where an axial-directional load was 50 gf, a sliding speed was 8 x 10³(m/s), and a PV value was 2.5 (N/mm²·m/s), an obtainable friction coefficient was 0.06. In this case, stainless steel (SUS420J2) had an outer diameter of 3mm and its end surface was configured into a spherical face having a radius of 4mm. On the other hand, when titanium (Ti) ion was implanted on the end surface of this pin by 5 x 10¹⁷ dose (ions/cm²) and subsequently carbon ion was implanted by 1.2 x 10¹⁸ dose (ions/cm²), an obtainable friction coefficient was in a stable range of 0.02 to 0.03 under the same sliding conditions.

Furthermore, a rotary shaft was made of the stainless steel (SUS420J2) having an outer diameter of 3mm and a non-modified spherical end surface having a radius of 4mm, while a bering was made of the disk-like SIALON. Then, using these rotary shaft and bearing, a spindle motor was driven at a rotational speed of 5,400 rpm under an axial-directional load of 60 gf for 300 Hr in the mixed lubricating condition. As a result, an axial-directional dislocation of the rotary shaft caused during this experiment was 14.8 µm. On the contrary, when titanium (Ti) ion is implanted on the end surface of the rotary shaft by 5 x 10¹⁷ dose (ions/cm²) and subsequently carbon ion was implanted by 1.2 x 10¹⁸ dose (ions/cm²), the axial-directional dislocation of the rotary shaft was reduced to 1.4 µm.

As explained above, forming a surface-modified layer on the steel material by applying the double ion implantation of titanium (Ti) ion and carbon ion is effective to reduce the friction coefficient and stably provide a small specific wear amount when the surface-modified layer is slid on an opponent material under the mixed lubricating condition.

Implantation amount of titanium (Ti) contributes the composition ratio in the modified layer; hence, it gives an influence to the sliding performance.

In this description, Pv value above-described is an index representing a load applied on the bearing which is calculated by multiplying a mean sliding surface pressure with a mean sliding speed. The mean sliding surface pressure is a value obtained by dividing the axial-directional load by a contact circle area derived from Hertz's contact theoretical equation. The mean sliding speed is equivalent to a half of a product of a circular length of the contact circle obtained from the Hertz's contact theoretical equation and the rotational speed.

In the present invention, the reason why the lower limit of titanium (Ti) implantation amount implanted into the rotary shaft is set to 2.5 x 10¹⁷ dose (ions/cm²) is that the dispersion of the axial-directional dislocation of the rotary shaft is surely suppressed and a low specific wear amount is stably obtained when the titanium (Ti) implantation amount is not smaller than this value.

Next, what kind of influence is given to the sliding performance by the hardness of the rotary shaft material and the sliding portion material of the bearing will be explained.

As described above, the mixed lubricating condition tends to cause the direct contact somewhere in the sliding surface between solid members. According to the adhesion theory, the real contact area is proportional to the load but is reverse proportional to the hardness. Accordingly, the real contact area is reduced with increasing hardness of the rotary shaft and the bearing when the load is constant. Reducing the ratio of the solid contact area to the apparent contact area results in a transition of the lubricating condition to a fluid lubricating condition, lowering the friction coefficient.

On the other hand, it was confirmed that the pivot thrust bearing system in accordance with the present invention can provide a specific wear amount not larger than 10⁻¹¹mm²/N when the friction coefficient is not larger than 0.07.

In the present invention, the reason why the lower limit of the hardness of the rotary shaft material is set to Hv500 and the lower limit of the hardness of the sliding portion of the bearing is set to Hv550 is that the ratio of the solid contact area to the apparent contact area is increased and the friction coefficient becomes larger than 0.07 when the hardness is smaller than these values.

Furthermore, the reason why the lower limit of the hardness of SIALON adopted in the present invention is set to Hv1300 is that SIALON having a hardness lower than this value is not practically available.

Next, what kind of influence is given to the sliding performance by the temperature of the ion-implantation surface when the end surface of the rotary shaft is subjected to the ion implantation.

When the rotary shaft is made of quenching material, there is a possibility that the temperature increase in the vicinity of the ion-implantation portion may partly anneal the quenched material, reducing the hardness of the material. For example, in the case of stainless steel (SUS420J2), Vickers hardness decreases with increasing annealing temperature as shown in Fig. 2. Such a hardness reduction due to the temperature increase in the vicinity of the ion-implantation portion of the rotary shaft will possibly increase the friction coefficient and therefore the wear amount is increased in the mixed lubricating condition, as described above.

The reason why the stainless steel (SUS420J2) is used for the rotary shaft and the upper limit of the temperature of the ion-implantation surface in the ion implantation is limited to 525 °C in the present invention is that, as apparent from Fig. 2, the hardness in the vicinity of the ion-implantation portion becomes smaller than the above-described hardness lower limit Hv500 of the rotary shaft material.

As described above, the present invention directly implants metal element ion and carbon ion into steel material of the rotary shaft, so that the ion-implantation surface of the rotary shaft is brought into slidable contact with the bearing material in the mixed lubricating condition through lubricating oil composition, thereby making it possible to suppress the dislocation of the rotary shaft in the axial direction and reduce the dispersion of the dislocation and, as a result, obtain a stable wear resistance.

Hereinafter, embodiments of the present invention will be explained with reference to the accompanying drawing.

### [Sliding of Rotary Shaft]

From the technical background represented by high-speed recording and high-densification of recording data in the field of magnetic disk apparatuses, it is required for a spindle motor that the axial-directional dislocation of the rotary shaft is suppressed within a small value less than 40µm under the condition that the load is 60 gf, the rotational speed is 5,400 rpm, and the rotation time is 10,000 Hr.

When the rotary shaft, having a spherical end surface with a radius of 4mm, is elastically brought into contact with a disk-like thrust bearing made of SIALON at the load 60 gf, it is assumed from the Hertz's contact theoretical equation that the radius of the contact circle is 24 µm, the maximum contact surface pressure is 45 kgf/mm² at the center of the axial end surface, and the sinking amount of the rotary shaft is 0.11 µm. According to such a thrust bearing, it is impossible to realize a non-contact condition by generating a stable dynamic pressure utilizing a hydraulic force of lubricating oil in response to the rotation of the shaft. Hence, the sliding condition of the rotary shaft is in the mixed lubricating condition. Furthermore, when the axial-directional dislocation of the rotary shaft is 40µm at the rotational speed of 5,400 rpm and the rotation time of 10,000 Hr, it is roughly assumed that the radius of the contact circle between the rotary shaft and the thrust bearing is 540 µm, the wear volume is 0.02 mm³, and the mean sliding radius is 200 µm in the final sliding condition. Hence, it is necessary that the specific wear amount is less than 10⁻¹¹mm²/N.

### [Ion Implantation Apparatus]

Ion implantation to the end surface of the rotary shaft was performed by using the MEVVA type ion beam generating apparatus disclosed in the earlier Japanese Patent Application No. HEI 7-52133, filed in 1995. Cathode material of titanium (Ti) or carbon is vaporized or evaporated by generating an arc discharge in a vacuum condition of 10⁻⁶ to 10⁻⁸ Torr until the vaporized particles are ionized. Then, the ionized particles are accelerated by the grid electrode applied a high voltage, and are taken out as ion beam and implanted into the steel material of the rotary shaft.

### (Embodiment 1)

Implantation amount of titanium (Ti) determines the composition ratio in the modified layer; hence, it gives an influence to the sliding performance.

### [Adjustment of Sample]

A sample used in this embodiment is an ion-implantation rotary shaft which is made of stainless steel (SUS420J2) having an outer diameter of 3mm with a spherical end surface having a radius of 4mm which is applied the double ion implantation of titanium (Ti) ion and carbon ion. The surface roughness of the end surface is set to Rmax = 0.3 to 1.1 µm. The surface roughness of the end surface of the rotary shaft is usually set in a range of Rmax < 0.5 µm. The hardness of the material is Hv651.

The implantation amount of titanium (Ti) is set to each of 1 x 10¹⁷, 2.5 x 10¹⁷, and 5 x 10¹⁷ dose (ions/cm²), while the implantation amount of carbon is fixed to 1.2 x 10¹⁸ dose (ions/cm²).

Furthermore, the thrust bearing is made of a disk-like SIALON. The surface roughness of the sliding surface is set in a range of Rmax < 0.1 µm. The hardness is Hv1590.

Moreover, the lubricating oil is Di-2-ethyl hexylsebacate (Mw426, η₄₀ 11.3 cps) with additive of butylester of stearic acid equivalent to 3 weight %.

### [Sliding Experiment]

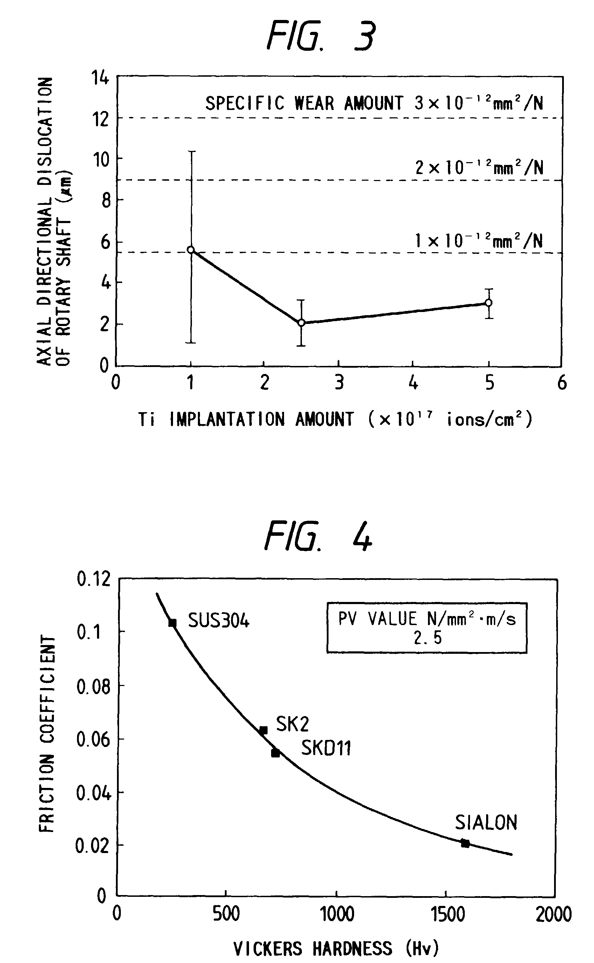

Fig. 3 shows an axial-directional dislocation (n=5) of the rotary shaft when a spindle motor is driven under the condition where an axial-directional load is 60 gf, the rotational speed is 5,400 rpm, and the rotation time is 3,300 Hr in the mixed lubricating condition.

As apparent from Fig. 3, the specific wear amount, calculated based on the axial-directional dislocation of the ion-implantation rotary shaft at the time 3,300 Hr has elapsed, is not larger than 2.5 x 10⁻¹²mm²/N when the titanium (Ti) implantation amount is 1 x 10¹⁷ dose (ions/cm²) and not larger than 1 x 10⁻¹²mm²/N when the titanium (Ti) implantation amount is 2.5 x 10¹⁷ or 5 x 10¹⁷ dose (ions/cm²). In any cases, the specific wear amount is not larger than 1 x 10⁻¹¹mm²/N.

Furthermore, when the titanium (Ti) implantation amount exceeds 2.5 x 10¹⁷ dose (ions/cm²), influence of the surface roughness of the sliding surface ruling the lubricating condition is reduced and, therefore, the specific wear amount is stabilized in a range not larger than 1 x 10⁻¹²mm²/N.

Accordingly, the pivot thrust bearing system in accordance with the present invention can suppress abnormal wear derived from the increase of surface roughness of the sliding surface, for example, by the presence of wounds produced in the machining process of the rotary shaft. Thus, it becomes possible to suppress any abrupt changes in the motor operation, enhancing the quality of the motor.

### (Embodiment 2)

The hardness of materials used for the rotary shaft and the sliding portion of the bearing is decisive in determining the friction coefficient under the mixed lubricating condition.

### [Adjustment of Sample]

A sample pin in this embodiment is made of stainless steel (SUS420J2) having an outer diameter of 3mm with a spherical end surface having a radius of 4mm which is applied the double ion implantation of titanium (Ti) ion and carbon ion. The surface roughness of the end surface is set in a range of Rmax < 0.15 pm. Furthermore, the hardness of the material is adjusted to be Hv500 through a thermal processing.

The implantation amount of titanium (Ti) is set to 5 x 10¹⁷ dose (ions/cm²), while the implantation amount of carbon is set to 1.2 x 10¹⁸ dose (ions/cm²).

Furthermore, an opponent material used in this embodiment is each of a disk-like SIALON (Hv1590), a carbon tool steel (SK2: Hv660), an alloy tool steel for cold dies (SKDII: Hv730) and a stainless steel (SUS304: Hv240). The surface roughness of the sliding surface is set in a range of Rmax < 0.2 µm. Moreover, the lubricating oil is Di-2-ethyl hexylsebacate (Mw426, η₄₀ 11.3 cps) with additive of butylester of stearic acid equivalent to 3 weight %.

### [Sliding Experiment]

A frictional experiment has been conducted by causing a reciprocative sliding movement under the mixed lubricating condition where a vertical load is 50 gf, the sliding speed is 8 x 10⁻³ m/s, and the PV value is 2.5 (N/mm²·m/s). Fig. 4 shows the relationship between the friction coefficient and the hardness of the sliding portion material used for the bearing, which is obtained from this experiment.

As apparent from Fig. 4, the friction coefficient reduces with increasing hardness of the sliding portion material of the bearing when the rotary shaft material has a hardness of Hv500. Furthermore, when the sliding portion material of the bearing has a hardness not smaller, than Hv550, the friction coefficient becomes less than 0.07 and the specific wear amount realized is not larger than 10⁻¹¹mm²/N. Especially, when SIALON having a small friction coefficient of 0.021 is used for a receiving plate member, the specific wear amount calculated based on the axial-direction dislocation (8µm) of the ion-implantation rotary shaft is 1 x 10⁻¹²mm²/N at the time 5,200 Hr has elapsed, as a result of a sliding experiment similar to the embodiment 1. Hence, in the mixed lubricating condition where both the boundary lubricating condition and the solid contact condition are complicatedly involved, it becomes possible to prevent the rotary shaft from causing a dislocation in the axial direction, thereby providing a stable and long-lasting wear resistance.

### (Embodiment 3)

### [Adjustment of Sample]

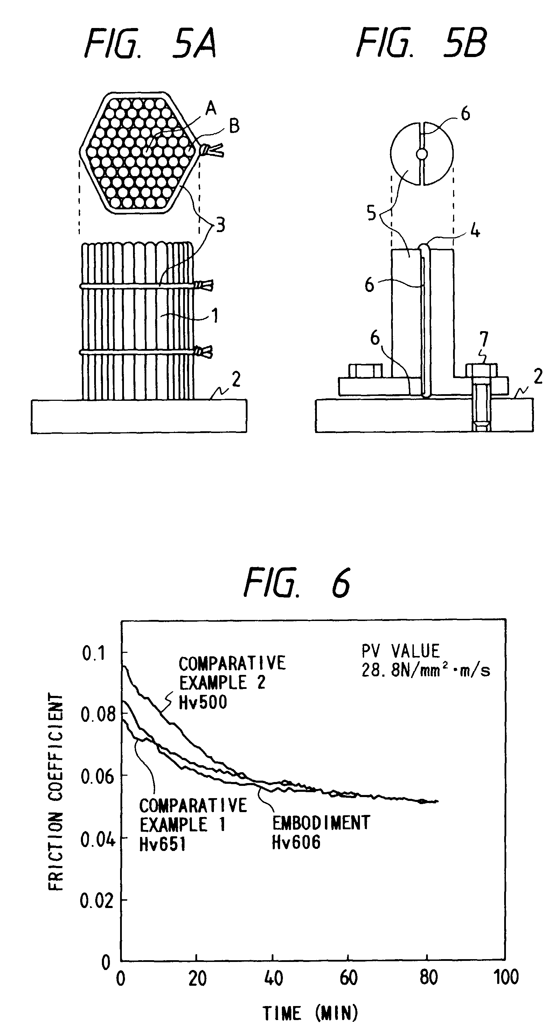

As shown in Fig. 5A, a total of 80 rods of stainless steels (SUS420J2), each having an outer diameter of 3mm and a spherical end surface with a radius of 4mm, are bundled densely, and are fixed by a wire 3 as a rotary shaft bundle 1. This rotary shaft bundle 1 is placed within a predetermined area defined by an effective ion beam irradiation radius (φ270mm) on a sample table 2 having a cooling function. Then, the double ion implantation of titanium (Ti) ion and carbon ion is applied on the end surface of the rotary shaft, thereby obtaining the ion-implantation rotary shaft embodying the present invention.

The implantation amount of titanium (Ti) is set to 5 x 10¹⁷ dose (ions/cm²), while the implantation amount of carbon is set to 1.2 x 10¹⁸ dose (ions/cm²). The beam current is 15 mA for both. The surface roughness of the end surface is adjusted to be in a range of Rmax < 0.15 µm. According to the measuring data, the ion-implantation surface material of the rotary shaft bundle has Vickers hardness of Hv606 at both of the center (A) and the outermost end (B) thereof. Namely, regarding the hardness, no difference is found in the radial direction of the rotary shaft bundle. It is believed that this phenomenon is caused by the small temperature gradient in the radial direction of the rotary shaft bundle, because the inside of the chamber is maintained at a high vacuum condition of 10⁻⁶ to 10⁻⁸ Torr and, hence, the heat radiation efficiency is remarkably small.

Fig. 5B shows a comparative example 1, according to which a rod 4 of stainless steel (SUS420J2) having the same configuration as the rod of Fig. 5A is covered by a thermo-conductive material 5 through a silicone rubber heat-transfer sheet 6. The stainless steel assembly is fixed on the sample table 2 by means of a screw 7 so as to be placed within the area defined by the effective ion beam irradiation radius (φ270mm). And, the ion implantation is performed by using the same kind and the same amount of ion. A resultant Vickers hardness of the ion-implantation surface of the stainless steel was Hv651.

As a comparative example 2, a rod of stainless steel (SUS420J2) having the same configuration as the rod of Fig. 5A is subjected to a thermal processing at a temperature not larger than 525 °C and is, thereafter, placed within the area defined by the effective ion beam irradiation radius (φ270mm) on the sample table 2 according to the method shown in Fig. 5A. Then, the ion implantation is performed by using the same kind and the same amount of ion. A resultant Vickers hardness of the ion-implantation surface of the stainless steel was Hv500.

Furthermore, an opponent material used in this comparative example 2 is a disk-like SIALON (Hv1590). The surface roughness of the sliding surface is adjusted to be in a range of Rmax < 0.1 µm.

Moreover, the lubricating oil used in this comparative example 2 is Di-2-ethyl hexylsebacate (Mw426, η₄₀ 11.3 cps) with additive of butylester of stearic acid equivalent to 3 weight %.

### [Sliding Experiment]

Fig. 6 shows the result of a frictional experiment conducted by causing a reciprocative sliding movement under the mixed lubricating condition where a vertical load is 150 gf, the sliding speed is 6.4 x 10⁻²m/s, and the PV value is 28.8 (N/mm²·m/s).

As apparent from Fig. 6, there is a tendency that the friction coefficient becomes large with reducing hardness of the ion-implantation surface material in the beginning of the experiment, however the friction coefficient is reduced with elapsing time and finally stabilized at 0.05 in all samples.

Furthermore, when a spindle motor of an axial-direction load 60 gf and a rotational speed of 5,400 rpm was driven for 300 Hr in the mixed lubricating condition, the specific wear amount (n=3) calculated based on the axial-direction dislocation (0.3 to 0.4µm) of the rotary shaft was not larger than 1 x 10⁻ ¹²mm²/N in all samples.

As described above, it becomes possible to prevent the rotary shaft from dislocating in the axial direction in the mixed lubricating condition when the rotary shaft is made of stainless steel (SUS420J2) and the temperature f the ion-implantation surface of the steel material is set in a range not larger than 525 °C in performing the ion implantation.

As apparent from the foregoing description, in the arrangement that the rotary shaft which is made by directly applying an ion implantation on a steel material surface is brought into slidable contact with the bearing through lubricating oil in the mixed lubricating condition where the boundary lubricating condition and the solid contact condition are complicatedly involved, the present invention can realize a stable sliding condition by specifying optimum ranges with respect to the titanium (Ti) implantation amount, the hardness of the materials used for the rotary shaft and the sliding portion of the bearing, and the temperature of the rotary shaft material and the ion-implantation surface in the ion implantation. Furthermore, the present invention makes it possible to suppress any abnormal wear derived from the increase of the surface roughness of the sliding surface, for example, by the presence of wounds produced in the machining process of the rotary shaft. Thus, it becomes possible to suppress any abrupt changes in the motor operation, enhancing the quality of the motor.

Although the above-described embodiments disclose the high-speed spindle motor incorporated in a magnetic disk apparatus, the pivot thrust bearing system in accordance with the present invention can be widely applied to various devices including a spindle motor driving a polygon mirror of a printer and other high-speed rotating devices.

As this invention may be embodied in several forms without departing from the essential characteristics thereof, the present embodiments described are therefore intended to be only illustrative and not restrictive, since the scope of the invention is defined by the appended claims.

## Claims

1. A pivot thrust bearing system comprising:
a rotary shaft made of steel material having an ion-implantation surface in which has been applied a direct ion implantation of metal element and carbon, said ion-implantation surface of said rotary shaft being brought into slidable contact with a bearing through a lubricating oil component, wherein
said metal element implanted into said rotary shaft is titanium (Ti), and an implantation amount of said titanium (Ti) is not smaller than 2.5 x 10¹⁷ dose (ions/cm²), while an implantation amount of said carbon is equivalent to or larger than the implantation amount of said titanium (Ti).

2. A pivot thrust bearing system in accordance with claim 1, wherein said steel material constituting said rotary shaft has Vickers hardness not smaller than Hv500, and a sliding portion of said bearing brought into slidable contact with said ion-implantation surface of said rotary shaft through said lubricating oil composition is made of metal or ceramic having Vickers hardness not smaller than Hv550.

3. A pivot thrust bearing system in accordance with claim 2, wherein said sliding portion of said bearing is made of SIALON having a composition of Si_{6-0.75x}Al_{0.07x}OₓN₈₋ₓ (x≤6) and having Vickers hardness not smaller than Hv1300.

4. A pivot thrust bearing system in accordance with claim 1, 2 or 3, wherein said steel material constituting said rotary shaft is stainless steel (SUS420J2).

5. A pivot thrust bearing system in accordance with claim 1, 2, 3 or 4, wherein an ion-implantation temperature of an ion-implantation surface of said steel material is not higher than 525°C in performing the ion implantation.
